Europäisches Patentamt

European Patent Office

Office européen des brevets

(19)

(11) Publication number: **0 238 206**
**A1**

(12) **EUROPEAN PATENT APPLICATION**

(21) Application number: **87301321.3**

(22) Date of filing: **16.02.87**

(51) Int. Cl.³: **H 01 L 21/26**

(30) Priority: **25.02.86 GB 8604583**

(43) Date of publication of application:
**23.09.87 Bulletin 87/39**

(84) Designated Contracting States:
**BE DE FR IT NL**

(71) Applicant: **UNITED KINGDOM ATOMIC ENERGY
AUTHORITY
11 Charles II Street
London SW1Y 4QP(GB)**

(72) Inventor: **Findlay, David James Sorley
5 Little Howe Close Radley
Abingdon Oxfordshire(GB)**

(74) Representative: **Wood, Paul Austin
Patents Branch United Kingdom Atomic Energy Authority
11 Charles II Street
London SW1Y 4QP(GB)**

(54) Photonuclear transmutation doping of semiconductors.

(57) A process and apparatus for doping semiconductor materials in which atoms of the semiconductor material are transmuted into atoms of the chosen dopant by means of photonuclear reactions.

EP 0 238 206 A1

Croydon Printing Company Ltd.

## Photonuclear Transmutation Doping of Semiconductors

The present invention relates to the production of semiconductor materials having desired conductivity characteristics. A particular example is the production of p-type silicon.

It is known that semiconductor materials, in particular silicon, can be doped by means of neutron capture followed by $\beta$-decay. However, in general, neutron irradiation leads to n-type material.

According to the present invention there is provided a process for producing semiconductor materials having specified conductivity characteristics, including the operation of subjecting a body of semiconductor material the conductivity characteristics of which are to conform to a given specification to irradiation by high energy photons thereby to produce within the body of semiconductor material by photonuclear reactions within atoms of the body of semiconductor material atoms of elements which are capable of imparting the desired conductivity characteristics to the semiconductor material, and terminating the irradiation when a specified level of conductivity has been reached.

The high energy photons may be in the form of bremsstrahlung radiation from an electron linear accelerator.

Also according to the present invention there is provided an apparatus for carrying out a process for producing semi-conductor materials having specified conductivity characteristics, comprising means for producing a beam of energetic particles, a target adapted to produce bremsstrahlung radiation the photons of which have a predetermined energy when the said energetic particles are incident upon it, means for scanning the beam of energetic particles over the surface of the target, and means for holding a body of semiconductor material to be irradiated in a position to receive the bremsstrahlung radiation.

In general photon irradiation leads to the production of p-type material, for example, p-type silicon can be produced by the creation of aluminium acceptors within the silicon by means of photons having energies of about 20 MeV. The relevant photonuclear reactions are $^{28}Si(\gamma, p)^{27}Al$ and $^{28}Si(\gamma, n)^{27}Si$ followed by the 4.2 s $\beta^+$ decay of $^{27}Si$ to $^{27}Al$. Photon energies of about 20 MeV are required to drive these reactions because although the $^{28}Si(\gamma, p)$ threshold is only 11.6 MeV, the largest cross-section occurs in the giant resonance between $\sim 17.5$ and $\sim 22.5$ MeV. Other examples include the production of p-type diamond semiconductor from the $^{12}C(\gamma,p)^{11}B$ and $^{12}C(\gamma,n)^{11}C \xrightarrow{\beta^+} {}^{11}B$ reactions, and the production of p-type silicon carbide from both the Si and C processes. Further possibilities include the production of p-type germanium and gallium arsenide, although the decays of some of the residual nuclei take longer.

The invention will now be described and explained by way of example, with reference to the accompanying schematic drawing of an apparatus for carrying out the invention.

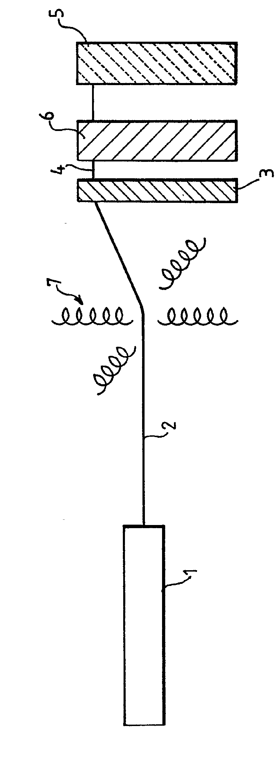

Referring to the drawing, an apparatus for irradiating a body of semiconductor material with high energy photons such as to cause photonuclear reactions within the body of semiconductor material, thereby to effect its electrical characteristics, consists of an electron linear accelerator 1 which produces a beam 2 of electrons. The electron beam 2 is incident upon a bremsstrahlung converter target 3, made of a metal of high atomic number such as tantalum or tungsten, in which it produces a beam of bremsstrahlung radiation 4, which falls upon a body 5 of semiconductor material to be treated. Between the bremsstrahlung converter target 3 and the body 5 of semiconductor material is a stopping block 6 of material of low atomic number, such as graphite or aluminium, which serves to prevent residual electrons emerging from the back of the bremsstrahlung converter 3 from falling directly on the body 5 of semiconductor material. The bremsstrahlung convertor target 3 has an area which is large enough to cover the front face of the body 5 of semiconductor material. A system of scanning electromagnets 7 enables the beam 2 of electrons to be scanned over the bremsstrahlung converter target 3, causing the beam 4 of bremsstrahlung radiation to be similarly scanned over the body 5 of semiconductor material. Both the bremsstrahlung converter target 3 and the stopping block 6 are water cooled. Alternatively, the body 5 of semiconductor material can be suitably rotated or otherwise moved in the bremsstrahlung beam 4.

As an approximate estimate of expected production rates where the body 5 of semiconductor material is silicon a $\sim$ 1mA $\sim$ 25MeV electron beam 2 from the electron linear accelerator 1 incident on a bremsstrahlung converter target 3 some 0.1 radiation lengths thick will produce $\sim$ 1 x $10^{14}$ photons $s^{-1}$ having energies between 17.5 and 22.5 MeV(assuming a 1/k bremsstrahlung spectrum). The sum of the cross-sections between 17.5 and 22.5 MeV for the photonuclear reactions $^{28}Si(\gamma, p)^{27}Al$ and $^{28}Si(\gamma, n)^{27}Si$ is $\sim$ 20 mb. If the beam 4 of bremsstrahlung radiation has an area of $\sim$10cm$^2$, and the body 5 of silicon is 1cm thick, then an acceptor production rate of 1 x $10^{10}cm^{-3}s^{-1}$ will be achieved.

As a simple example of improving uniformity of doping as a function of depth within a block of silicon, the block could be irradiated from first one side then the other. The bremsstrahlung beam 4 is attenuated as it penetrates the body of silicon 5, but the attenuation coefficient for 20 MeV photons in silicon is only 0.023 $cm^2g^{-1}$, which gives an attenuation length of 18cm. Hence by irradiating first from one side, and then from the opposite side, a block 5 of silicon some 18cm thick could be doped, with a uniformity of $^{+0}_{-11}$% throughout its thickness, to $10^{13}$ acceptors $cm^{-3}$ at a rate of $\sim$ 3 s per gram of silicon doped. For better uniformity, $^{+0}_{-2}$% achieved with a 7 cm thick block of silicon at $\sim$ 7 s $g^{-1}$.

The process can be used for other semiconductor materials and types providing that nuclides exist which will undergo appropriate photonuclear reactions.

Claims

1    A process for producing semiconductor materials having specified conductivity characteristics, including the operation of subjecting a body (5) of semiconductor material the conductivity characteristics of which are to conform to a given specification to irradiation by high energy photons thereby to produce within the body (5) of semiconductor material by photonuclear reactions within atoms of the body (5) of semiconductor material atoms of elements which are capable of imparting the desired conductivity characteristics to the semiconductor material, and terminating the irradiation when a specified level of conductivity has been reached.

2    A process according to claim 1 wherein the high energy photons are in the form of bremsstrahlung radiation (4).

3    A process according to claim 2 wherein the bremsstrahlung radiation (4) is produced by an electron accelerator.

4    A process according to any preceding claim wherein the semiconductor material (5) is silicon.

5    A process according to claim 4 wherein the photons have energies in the range of 11.6 MeV to 22.5 MeV so as to produce aluminium acceptors in the silicon by means of the photonuclear reaction $^{28}Si$ $(\gamma, p)$ $^{27}Al$.

6    A process according to claim 4 wherein the photons have an energy such as to produce aluminium acceptors in the silicon by means of the photonuclear reaction $^{28}Si$ $(\gamma, n)$ $^{27}Si$ followed by the $4.2s$ $\beta^+$ decay of $^{27}Si$ to $Al^{27}$.

7    A process according to any of claims 1 to 3 wherein the semiconductor material is diamond and the photons have an energy such as to induce the photonuclear reactor $^{12}C(\gamma,p)$ $^{11}B$.

8    A process according to any of claims 1 to 3 wherein the semiconductor material is diamond and the photons have as energy such as to induce the photonuclear reaction $^{12}C(\gamma,n)\xrightarrow{\beta^+} {}^{11}B$.

9    An apparatus for carrying out a process according to claim 1 comprising means (1) for producing a beam of energetic particles (2) a target (3) adapted to produce bremsstrahlung radiation (4) the photons of which have a predetermined energy when the said energetic particles (2) are incident upon it, means (7) for scanning the beam of energetic particles (2) over the surface of the target(3) and means for holding a body (5) of semiconductor material to be irradiated in a position to receive the bremsstrahlung radiation (4).

10    An apparatus according to claim 9 wherein the means (1) for producing a beam of energetic particles (2) comprises an electron accelerator.

11    An apparatus according to claim 9 or claim 10 wherein the means (7) for scanning the beam (2) of energetic particles over the target (3) comprises a system of electromagnets (7).

12    An apparatus according to any of claims 9 to 11 including means (6) for preventing the energetic particles (2) from being incident directly upon the body of semiconductor material (5).

13   A process substantially as hereinbefore described and with reference to the accompanying drawing.

14   An apparatus substantially as hereinbefore described and with reference to the accompanying drawing.

**0238206**
Application number

European Patent
Office

**EUROPEAN SEARCH REPORT**

EP 87 30 1321

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| P,X | SOVIET PHYSICS SEMICONDUCTORS, vol. 20, no. 4, April 1986, pages 397-399, American Institute of Physics, New York, US; V.V. ZABLOTSKII et al.: "Doping of semiconductors by photonuclear reactions" * Table I * | 1-6,13 | H 01 L 21/26 |
| X | PHYSICS BRIEFS, vol. 5, no. 4, 1982, page 1443, abstract no. 22486, Karslruhe, DE; L.S. SMIRNOV et al.: "Semiconductor doping by the nuclear reaction method", & NOVOSIBIRSK, Nauka, 1981 | 1-4,13 | |
| X | CHEMICAL ABSTRACTS, vol. 74, 1971, page 336, abstract no. 81036u, Columbus, Ohio, US; U.A. ARIFOV et al.: "Doping of silicon by photonuclear reactions", & KRIST. TONKIKH PLENOK 1970, 133-6  --- -/- | 1-6,13 | **TECHNICAL FIELDS SEARCHED (Int. Cl.4)** H 01 L |

The present search report has been drawn up for all claims

| Place of search | Date of completion of the search | Examiner |
|---|---|---|
| THE HAGUE | 10-07-1987 | VANCRAEYNEST F.H. |

# DOCUMENTS CONSIDERED TO BE RELEVANT

Page  2

| Category | Citation of document with indication, where appropriate, of relevant passages | Relevant to claim | CLASSIFICATION OF THE APPLICATION (Int. Cl.4) |
|---|---|---|---|
| A | PHYSICAL REVIEW C, vol. 27, no. 2, February 1983, pages 470-480, The American Physical Society, New York, US; R.L. GULBRANSON et al.: "Charged particle decay of the 28Si giant electric dipole resonance" <br> * Page 472, figure 2; page 475, column 2, paragraph 2; figure 1 * | 5 | |
| X | <br> * IDEM * | 9-12, 14 | |
| A | PHYSICAL REVIEW C, vol. 27, no. 3, March 1983, pages 960-975, The American Physical Society, New York, US; R.E. PYWELL et al.: "Photoneutron cross sections for the silicon isotopes" <br> * Table I * | 5,6 | TECHNICAL FIELDS SEARCHED (Int. Cl.4) |
| X | IDEM | 9-12, 14 | |
| A | NUCLEAR PHYSICS, vol. A373, 1982, pages 445-482; M. CAVINATO et al.: "Photoreactions of 12C, 160 and 40Ca in self-consistent RPA theory" <br> * Table 2 * | 7,8 | |

The present search report has been drawn up for all claims

| Place of search | Date of completion of the search | Examiner |
|---|---|---|
| THE HAGUE | 10-07-1987 | VANCRAEYNEST F.H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO Form 1503 03.82